# EUROPEAN PATENT APPLICATION

(11) **EP 4 171 053 A1**
(43) Date of publication of application: **26.04.2023**
(21) Application number: 22200814.6
(22) Date of filing: 11.10.2022
(51) Int. Cl.: H04N 25/00, H04N 25/79

(54) **PHOTOELECTRIC CONVERSION DEVICE, LIGHT EMITTING DEVICE, PHOTOELECTRIC CONVERSION SYSTEM, AND MOVING BODY**

(30) Priority: 20.10.2021 JP 2021171902; 05.08.2022 JP 2022125851
(71) Applicant: CANON KABUSHIKI KAISHA, Ohta-ku Tokyo 146-8501 (JP)
(72) Inventor: KOBAYASHI, Hideo, Ohta-ku 146-8501 (JP); MIKAJIRI, Satoru, Ohta-ku 146-8501 (JP); MUTO, Hiroyuki, Ohta-ku 146-8501 (JP); NAKAJIMA, Yuji, Ohta-ku 146-8501 (JP); YOSHIDA, Daisuke, Ohta-ku 146-8501 (JP)
(74) Representative: TBK

(57) **Abstract**

A photoelectric conversion device includes a pixel array including a plurality of pixels, a signal processor including an A/D conversion device configured to convert an analog signal output from the pixel array into a digital signal, and an output device configured to output, based on a signal output from the signal processor, an amplitude modulated signal having an amplitude value selected from three or more amplitude values.

## Description

### BACKGROUND OF THE INVENTION

### Field of the Invention

The present invention relates to a photoelectric conversion device, a light emitting device, a photoelectric conversion system, and a moving body.

### Description of the Related Art

International Publication No. WO2014/007004 discloses a solid-state image capturing device including a pixel array unit, a driving unit that drives the pixel array unit, a signal processor, a memory unit, a data processor, and a control unit. The signal processor performs signal processing including digitalization (A/D-conversion) on a signal read out from the pixel array unit. The memory unit stores image data having undergone signal processing by the signal processor. The data processor performs processing of reading out, in a predetermined order, image data stored in the memory unit and outputting the image data to the outside of the chip.

### SUMMARY OF THE INVENTION

The present invention in its first aspect provides a photoelectric conversion device as specified in claims 1 to 19.

The present invention in its second aspect provides a moving body as specified in claim 20.

The present invention in its third to sixth aspects provide systems as specified in claims 21 to 25, respectively.

The present invention in its seventh aspect provides a light emitting device as specified in claims 26 to 29.

Further features of the present invention will become apparent from the following description of exemplary embodiments with reference to the attached drawings.

### BRIEF DESCRIPTION OF THE DRAWINGS

Fig. 1 is a view showing an arrangement example of a photoelectric conversion device according to the first embodiment;
Fig. 2 is a view showing an arrangement example of a pixel of the photoelectric conversion device;
Fig. 3 is a view showing an arrangement example of an output device of the photoelectric conversion device;
Fig. 4 is a view showing an arrangement example of a transmitter of the output device;
Fig. 5 is a table showing operation examples of a decoder;
Fig. 6 is a view for explaining an operation example of the transmitter;
Fig. 7 is a view for explaining another operation example of the transmitter;
Fig. 8 is a view for explaining still another operation example of the transmitter;
Fig. 9 is a view for explaining still another operation example of the transmitter;
Fig. 10 is a view for explaining the operation examples of the transmitter;
Figs. 11A and 11B are views showing a layout example of the photoelectric conversion device;
Fig. 12 is a view showing an arrangement example of the output device, a signal processor, and a pad group;
Fig. 13 is a view showing a first modification of the transmitter;
Fig. 14 is a view showing a second modification of the transmitter;
Figs. 15A and 15B are views showing a third modification of the transmitter;
Fig. 16 is a view showing an arrangement example of a light emitting device according to the second embodiment;
Fig. 17 is a view showing an arrangement example of a light emitting unit;
Fig. 18 is a view showing an arrangement example of a photoelectric conversion system;
Figs. 19A and 19B are views showing an arrangement example of a photoelectric conversion system and an arrangement example of a moving body, respectively;
Fig. 20 is a flowchart illustrating an operation example of the photoelectric conversion system;
Fig. 21 is a view showing a first example of a system including the photoelectric conversion device;
Fig. 22 is a view showing a second example of the system including the photoelectric conversion device;
Fig. 23 is a view showing a third example of the system including the photoelectric conversion device;
Fig. 24 is a view showing a fourth example of the system including the photoelectric conversion device; and
Fig. 25 is a view showing a transmitter (second output device) applicable to the fourth example of the system including the photoelectric conversion device.

### DESCRIPTION OF THE EMBODIMENTS

In recent years, it is becoming a problem that, in a system including a semiconductor device such as a photoelectric conversion device or a light emitting device and another device, the signal transfer rate between the semiconductor device and the other device can limit the performance of the entire system.

One of aspects of the disclosed invention provides a technique advantageous in increasing the signal transfer rate from a photoelectric conversion device to another device.

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

A photoelectric conversion device PEC according to the first embodiment will be described below. The photoelectric conversion device PEC can be formed as, for example, an image capturing device, but the photoelectric conversion device PEC may be formed as, for example, another device such as a distance measurement device or a light measurement device. The distance measurement device can be formed as, for example, a focus detection device or a TOF (Time of Flight) distance measurement device. The light measurement device can be configured to measure, for example, the light intensity distribution within the field of view of a camera.

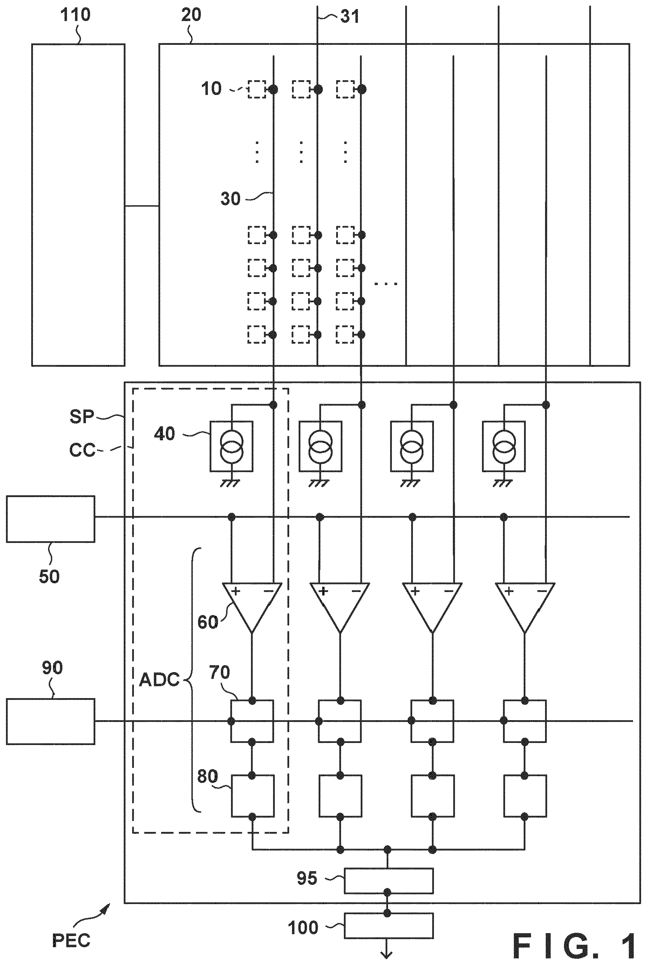

Fig. 1 schematically shows the arrangement of the photoelectric conversion device PEC. The photoelectric conversion device PEC can be formed in a form of a semiconductor chip. The semiconductor chip may include a stacked structure formed by a plurality of substrates. The photoelectric conversion device PEC can include, for example, a pixel array 20, a signal processor SP, and a row selection circuit (vertical scanning circuit) 110. The signal processor SP can include a plurality of column circuits CC. The pixel array 20 can include a plurality of pixels 10 and a plurality of vertical signal lines. The plurality of pixels 10 can be arranged so as to form a plurality of rows and a plurality of columns. The row selection circuit 110 can be configured to select, in a predetermined order, the plurality of rows formed by the array of the plurality of pixels 10 in the pixel array 20.

In the example shown in Fig. 1, the plurality of vertical signal lines of the pixel array 20 include vertical signal lines 30 arranged in odd-numbered columns and vertical signal lines 31 arranged in even-numbered columns, but this is not intended to limit the invention. Further, in the example shown in Fig. 1, column circuits (the plurality of column circuits CC in Fig. 1) that process signals output via the vertical signal lines 30 arranged in the odd-numbered columns and column circuits (not shown) that process signals output via the vertical signal lines 31 arranged in the even-numbered columns can be provided spaced apart from each other. However, this is not intended to limit the invention. The column circuits CC that process signals corresponding to the odd-numbered columns will be described below, but the column circuits that process signals corresponding to the even-numbered columns can have the structure similar to that of the column circuits CC that process signals corresponding to the odd-numbered columns.

Each column circuit CC can include, for example, a current supply circuit 40 that supplies a current to the vertical signal line 30, among a plurality of the vertical signal lines 30, corresponding to this column circuit CC. The column circuit CC may include a comparator 60 that compares the value of a signal supplied from the corresponding vertical signal line 30 with the value of a ramp signal supplied from a ramp signal generation circuit 50. The column circuit CC may include a first memory 70 that holds a count value which is supplied from a counter 90 in accordance with the inversion of the output of the comparator 60. The counter 90 may be commonly provided for the plurality of the vertical signal lines 30, or may be individually provided for each of the plurality of the vertical signal lines 30. The comparator 60 and the first memory 70 can form an A/D convertor ADC that generates a digital signal corresponding to the signal (analog signal) supplied from the vertical signal line 30. The column circuit CC may include a second memory 80 that receives the signal (digital signal) held by the first memory 70. The signal processor SP or the column circuit CC may include another circuit (for example, an analog amplification circuit or a CDS circuit).

The signal processor SP can include a processing circuit (for example, digital processing circuit) 95 that processes signals supplied from a plurality of the second memories 80 or column circuits CC. The processing circuit 95 may include a column selection circuit (horizontal scanning circuit) that selects and outputs, in a predetermined order, signals output from the plurality of the column circuits CC, respectively. The photoelectric conversion device PEC can include an output device 100 that outputs the signal generated by processing performed by the processing circuit 95. The processing circuit 95 may be configured to output an image signal generated using the plurality of pixels 10, or may be configured to output a signal obtained by processing the image signal generated using the plurality of pixels 10.

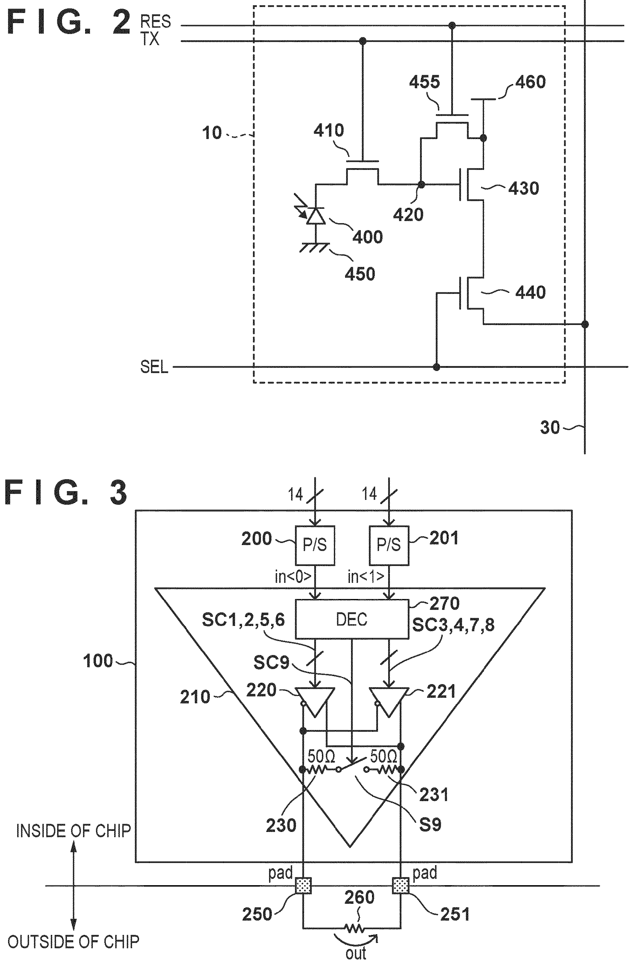

Fig. 2 shows an arrangement example of each pixel 10. The pixel 10 includes at least a photoelectric conversion element 400. The photoelectric conversion element 400 can be, for example, a photodiode. The pixel 10 can also include a floating diffusion 420, and a transfer transistor 410 that transfers, to the floating diffusion 420, electric charges generated by the photoelectric conversion element 400. The gate of the transfer transistor 410 can be connected to a transfer control line TX driven by the row selection circuit 110. When the voltage of the transfer control line TX is driven to the active level, the transfer transistor 410 can transfer, to the floating diffusion 420, electric charges generated by the photoelectric conversion element 400. The floating diffusion 420 can function as a charge/voltage conversion device that converts the electric charges transferred from the photoelectric conversion element 400 by the transfer transistor 410 into a voltage (potential).

The pixel 10 can also include a reset transistor 455 that resets the voltage (potential) of the floating diffusion 420. The gate of the reset transistor 455 can be connected to a reset control line RES driven by the row selection circuit 110. When the voltage of the reset control line RES is driven to the active level, the reset transistor 455 can reset the voltage (potential) of the floating diffusion 420. The pixel 10 can also include an amplification transistor 430 that outputs, to the vertical signal line 30, a signal corresponding the voltage (potential) of the floating diffusion 420. The amplification transistor 430 and the above-described current supply circuit 40 can form a source follower amplification circuit. The pixel 10 may also include a selection transistor 440 used to set the pixel 10 in a selected state or an unselected state. The gate of the selection transistor 440 can be connected to a selection control line SEL driven by the row selection circuit 110. When the voltage of the selection control line SEL is driven to the active level, the selection transistor 440 sets the pixel 10 in the selected state. When the voltage of the selection control line SEL is driven to the inactive level, the selection transistor 440 sets the pixel 10 in the unselected state.

The pixel 10 is not limited to the arrangement described above, and various changes can be made. For example, the pixel 10 may have a function to change the capacitance value of the floating diffusion 420. In other words, the pixel 10 may have a function to change the sensitivity of the floating diffusion 420. The pixel 10 may be formed such that a plurality of the photoelectric conversion elements 400 share the floating diffusion 420. The pixel 10 may be a pixel that can assign such the plurality of the photoelectric conversion elements 400 to one microlens and detect the phase difference.

Fig. 3 shows an arrangement example of the output device 100. Parallel signals each formed by a plurality of bits can be supplied from the processing circuit 95 to the output device 100. One parallel signal can include signals of one pixel 10 (for example, signals each of which is output from the pixel 10 and A/D-converted by the A/D convertor ADC, and then processed by the processing circuit 95). In the example shown in Fig. 3, two sets of the parallel signals each formed by 14 bits are supplied from the processing circuit 95 to the output device 100. The photoelectric conversion device PEC can be formed as a semiconductor chip, and include output pads 250 and 251. The output pads 250 and 251 can be connected to each other by a terminating resistor 260 that can be provided outside the semiconductor chip.

The output device 100 can include, for example, parallel/serial convertors 200 and 201 and a transmitter 210. In an example, the signals of one pixel 10 can be supplied simultaneously or in parallel as the parallel signal (parallel data) from the processing circuit 95 to the parallel/serial convertor 200. In addition, the signals of one other pixel 10 can be supplied simultaneously or in parallel as the parallel signal (parallel data) from the processing circuit 95 to the parallel/serial convertor 201. Each of the parallel/serial convertors 200 and 201 can convert the supplied parallel signal into a serial signal, and supply the serial signal to the transmitter 210. In the example shown in Fig. 3, the parallel/serial convertor 200 converts the supplied parallel signal into a serial signal, and supplies the serial signal to the transmitter 210 as a serial signal in<0>. The parallel/serial convertor 201 can convert the supplied parallel signal into a serial signal, and supply the serial signal to the transmitter 210 as a serial signal in<1>.

In the example shown in Fig. 3, the transmitter 210 is configured to output an amplitude modulated signal (a pulse amplitude modulation signal) with 2-bit information at one time. In other words, the transmitter 210 is configured to output an amplitude modulated signal (a pulse amplitude modulation signal) having an amplitude value selected from four amplitude values. Note that the transmitter 210 can be configured to output an amplitude modulated signal (a pulse amplitude modulation signal) having an amplitude value selected from an arbitrary one of three or more (for example, four, six, eight, or the like) amplitude values. In the example shown in Fig. 3, the transmitter 210 include a decoder 270, 1-bit transmitters 220 and 221, resistors 230 and 231, and a switch S9.

As an example, at a given timing, the LSB value in the 14-bit parallel signal of one pixel 10 is supplied as the serial signal in<0> from the parallel/serial convertor 200 to the transmitter 210 (decoder 270). At the same time, the LSB value in the 14-bit parallel signal of one other pixel 10 is supplied as the serial signal in<1> from the parallel/serial convertor 201 to the transmitter 210 (decoder 270). The transmitter 210 outputs, between the output pads 250 and 251 (between the both ends of the terminating resistor 260), an amplitude modulated signal (a pulse amplitude modulation signal), which has an amplitude value selected from four amplitudes in accordance with the two inputs, as a differential output voltage out. That is, the amplitude modulated signal or differential output voltage out output between the output pads 250 and 251 (between the both ends of the terminating resistor 260) by the transmitter 210 can take one of four amplitude values in accordance with the values of two serial signals in<1> and in<0>. In this manner, the output device 100 outputs the signal with 2-bit information from the output pads 250 and 251 at one time.

With this, it is possible to increase the signal transfer rate from the photoelectric conversion device PEC to another device. From another point of view, according to the photoelectric conversion device PEC, it is possible to increase the signal transfer rate from the photoelectric conversion device PEC to another device while suppressing an increase in the number of output pads required to output signals of the pixel array 20. This is useful for increasing the number of power supply potential pads and ground potential pads for the pixel array 20, the comparator 60 (A/D convertor), the first memory 70, the second memory 80, and the like, and suppressing a degradation in image quality.

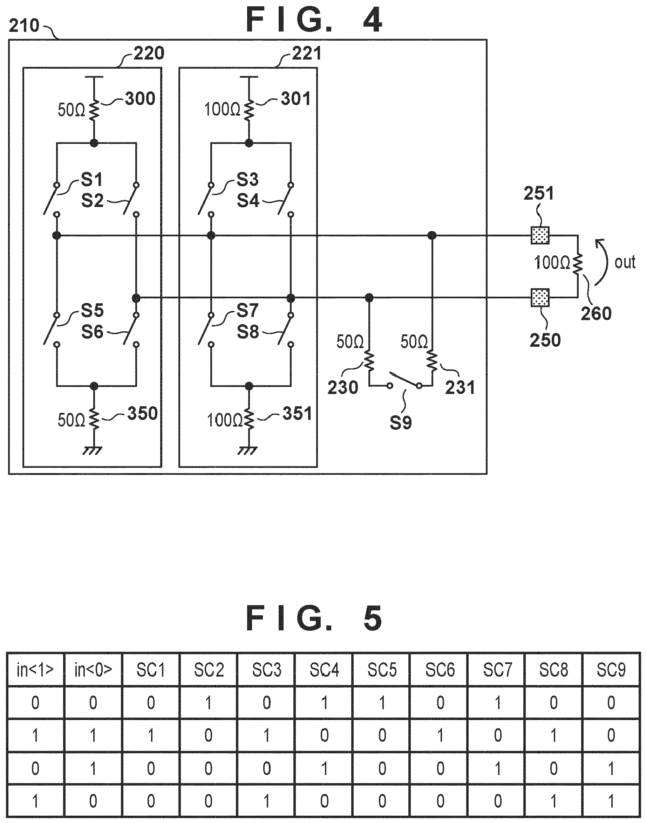

Fig. 4 shows an arrangement example of the 1-bit transmitters 220 and 221 constituting the transmitter 210. The 1-bit transmitter 220 can include, for example, a resistor 300, switches S1, S2, S5, and S6, and a resistor 350. Similarly, the 1-bit transmitter 221 includes, for example, a resistor 301, switches S3, S4, S7, and S8, and a resistor 351. In the example shown in Fig. 4, each of the resistors 300 and 350 of the 1-bit transmitter 220 is of 50 Ω, and each of the resistors 301 and 351 of the 1-bit transmitter 221 is of 100 Ω, which is different from the resistance values of the resistors 300 and 350. The transmitter 210 further includes resistors 230 and 231 and a switch S9.

Fig. 5 illustrates operations of the decoder 270. The decoder 270 can include input terminals that receive the serial signals in<1> and in<0>, respectively, and output terminals that output switch control signals SC1 to SC9, respectively. The switch control signals SC1 to SC9 are supplied to the switches S1 to S9, respectively. In this example, if the value of each of the switch control signals SC1 to SC9 is 1, the corresponding one of the switches S1 to S9 is set in an ON state (conductive state), and if the value of each of the switch control signals SC1 to SC9 is 0, the corresponding one of the switches S1 to S9 is set in an OFF state (nonconductive state).

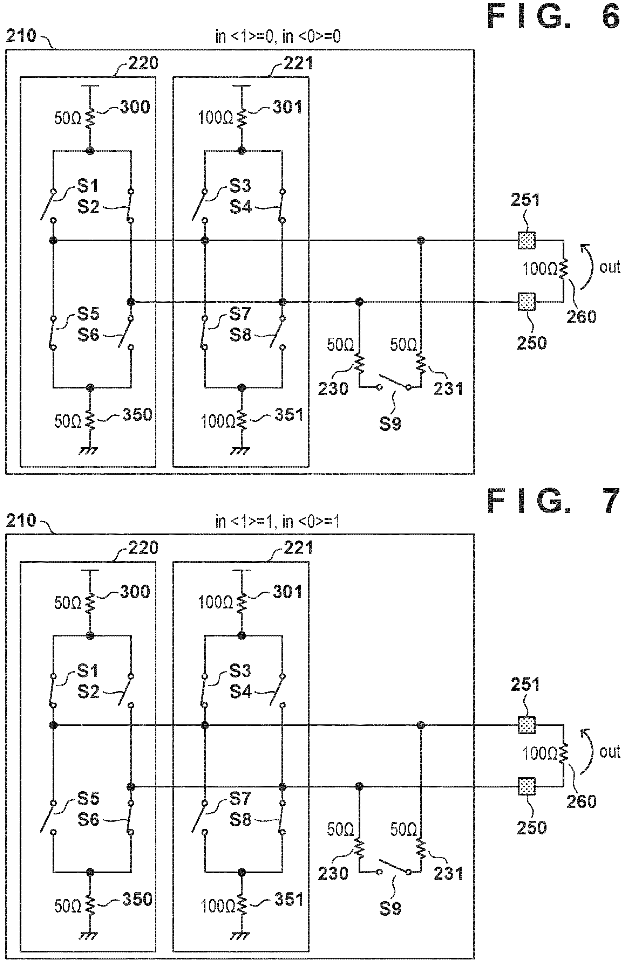

Fig. 6 shows the operation states of the switches S1 to S9 in the transmitter 210 in a case of the serial signal in<1> = 0 and the serial signal in<0> = 0. As shown in Fig. 6, each of the switches S2, S4, S5, and S7 is set in the ON state, and each of the remaining switches S1, S3, S6, S8, and S9 is set in the OFF state. If each of the switches S2 and S4 is set in the ON state, the resistors 300 and 301 are connected in parallel between the power supply potential and the output pad 250, resulting in a combined resistance of about 33 Ω. If each of the switches S5 and S7 is set in the ON state, the resistors 350 and 351 are connected in parallel between the ground potential and the output pad 251, resulting in a combined resistance of about 33 Ω. For example, when the power supply potential is 0.5 V, the potential of the output pad 250 is 400 mV, and the potential of the output pad 251 is 100 mV. Thus, the differential output voltage out is - 300 mV.

Fig. 7 shows the operation states of the switches S1 to S9 in the transmitter 210 in a case of the serial signal in<1> = 1 and the serial signal in<0> = 0. As shown in Fig. 7, each of the switches S1, S3, S6, S8 is set in the ON state, and each of the remaining switches S2, S4, S5, S7, and S9 is set in the OFF state. If each of the switches S1 and S3 is set in the ON state, the resistors 300 and 301 are connected in parallel between the power supply potential and the output pad 251, resulting in a combined resistance of about 33 Ω. If each of the switches S6 and S8 is set in the ON state, the resistors 350 and 351 are connected in parallel between the ground potential and the output pad 250, resulting in a combined resistance of about 33 Ω. For example, when the power supply potential is 0.5 V, the potential of the output pad 251 is 400 mV, and the potential of the output pad 250 is 100 mV. Thus, the differential output voltage out is +300 mV.

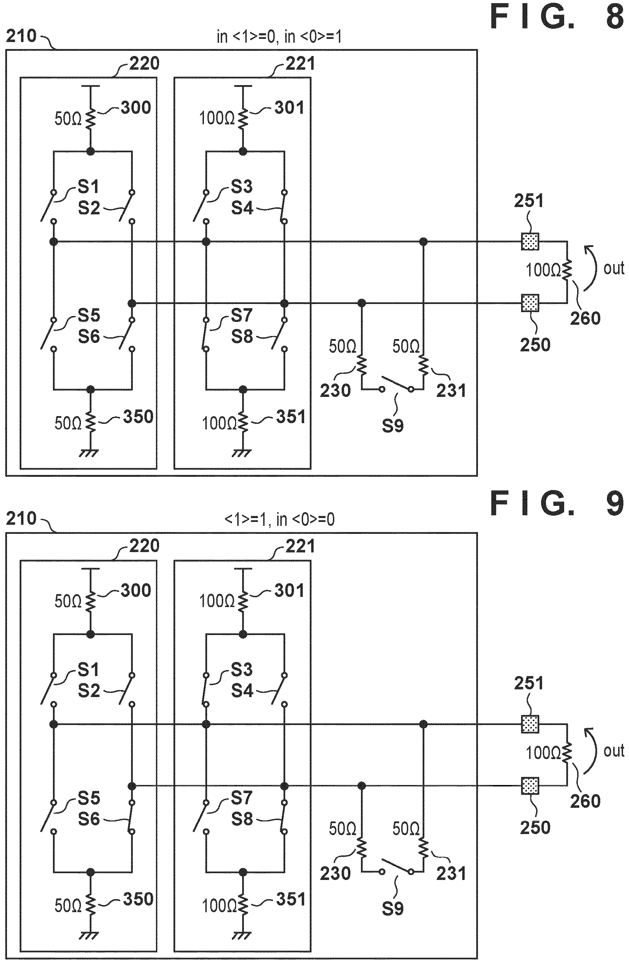

Fig. 8 shows the operation states of the switches S1 to S9 in the transmitter 210 in a case of the serial signal in<1> = 0 and the serial signal in<0> = 1. As shown in Fig. 8, each of the switches S4, S7, and S9 is set in the ON state, and each of the remaining switches S1, S2, S3, S5, S6, and S8 is set in the OFF state. If the switch S4 is set in the ON state, the resistor 301 is connected between the power supply potential and the output pad 250, resulting in a resistance of 100 Ω. If the switch S7 is set in the ON state, the resistor 351 is connected between the ground potential and the output pad 251, resulting in a resistance of 100 Ω. In addition, if the switch S9 is set in the ON state, the resistors 230 and 231 are connected between the output pad 250 and the output pad 251 in addition to the terminating resistor 260, resulting in a combined resistance of 50 Ω. Accordingly, for example, when the power supply potential is 0.5 V, the potential of the output pad 250 is 300 mV, and the potential of the output pad 251 is 200 mV. Thus, the differential output voltage out is -100 mV.

Fig. 9 shows the operation states of the switches S1 to S9 in the transmitter 210 in a case of the serial signal in<1> = 1 and the serial signal in<0> = 0, the serial signals in<1> and in<0> being shown in Fig. 3. As shown in Fig. 9, each of the switches S3, S8, and S9 is set in the ON state, and each of the remaining switches S1, S2, S4, S5, S6, and S7 is set in the OFF state. If the switch S3 is set in the ON state, the resistor 301 is connected between the power supply potential and the output pad 251, resulting in a resistance of 100 Ω. If the switch S8 is set in the ON state, the resistor 351 is connected between the ground potential and the output pad 250, resulting in a resistance of 100 Ω. In addition, if the switch S9 is set in the ON state, the resistors 230 and 231 are connected between the output pad 250 and the output pad 251 in addition to the terminating resistor 260, resulting in a combined resistance of 50 Ω. Accordingly, for example, when the power supply potential is 0.5 V, the potential of the output pad 251 is 300 mV, and the potential of the output pad 250 is 200 mV. Thus, the differential output voltage out is +100 mV.

As has been described above, in the example shown in Fig. 4, the output device 100 includes a voltage dividing circuit that can change the voltage division ratio, and the output signal of the output device 100, that is, the amplitude modulated signal is generated by changing the voltage division ratio of the voltage dividing circuit. The voltage division ratio is controlled by the decoder 270 that generates the switch control signals SC1 to SC9 based on the serial signals in<1> and in<0>.

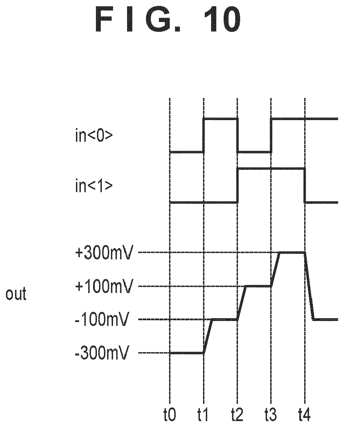

Fig. 10 shows four amplitude values of the differential output signal out of the output device 100 corresponding to four combinations of input values of the serial signals in<1> and in<0>. In the examples described with reference to Figs. 4 to 10, the output device 100 or the transmitter 210 outputs the amplitude modulated signal having the amplitude value selected from four amplitude values.

Note that in the example shown in Fig. 3, the signal of the pixel 10 is a 14-bit signal, but this is merely an example and the present invention is not limited to this. The signal of the pixel 10 can be quantized to an arbitrary number of bits, for example, 10 bits, 12 bits, 16 bits, or the like.

Further, in the example shown in Fig. 3, the value of a given bit (for example, LSB) of the digital signal of one pixel 10 and the value of the identical bit (for example, LSB) of the digital signal of another pixel 10 are simultaneously supplied to the transmitter 210. In this case, for example, an amplitude modulated signal having undergone amplitude modulation (pulse amplitude modulation) based on the LSB value of the digital signal of the given pixel 10 and the LSB value of the digital signal of the other pixel 10 is output from the output device 100. Then, an amplitude modulated signal having undergone amplitude modulation based on the values of the second bits of the two pixels is output from the output device 100. Thereafter, amplitude modulated signals having undergone amplitude modulation based on the values of the third bits and subsequent bits are sequentially output from the output device 100. Finally, an amplitude modulated signal having undergone amplitude modulation based on the MSB values of the digital signals of the two pixels is output from the output device 100.

The above-described arrangement has a merit that the arrangement of the signal processor or an external device (for example, processor), which receives the amplitude modulated signal output from the output device 100 of the photoelectric conversion device PEC, can easily share the arrangement for receiving a binary output. More specifically, assume that in a case of a binary output, signals are output in the order of the LSB, the second bit,..., and the MSB of the digital signal of one pixel. Then, in a case of a quaternary output, signals are output in the order of the LSBs, the second bits,..., and the MSBs of two pixels. Accordingly, after the signal for two pixels is first separated (decoded), exactly the same signal processing as for the binary output can be performed. Note that another arrangement such as an arrangement in which the LSB value and the MSB value of the same pixel are simultaneously output may be employed.

The resistance values of the resistors 300, 301, 350, 351, 230, and 231 in the above description are merely examples. These resistance values can be adjusted to adjust the amplitude and output resistance of the output signal. For example, the resistors 300 and 350 may be of 60 Ω or 70 Ω larger than 50 Ω. In this case, the amplitude of the output signal is adjusted from ±300 mV to a direction in which the absolute value decreases in Fig. 10.

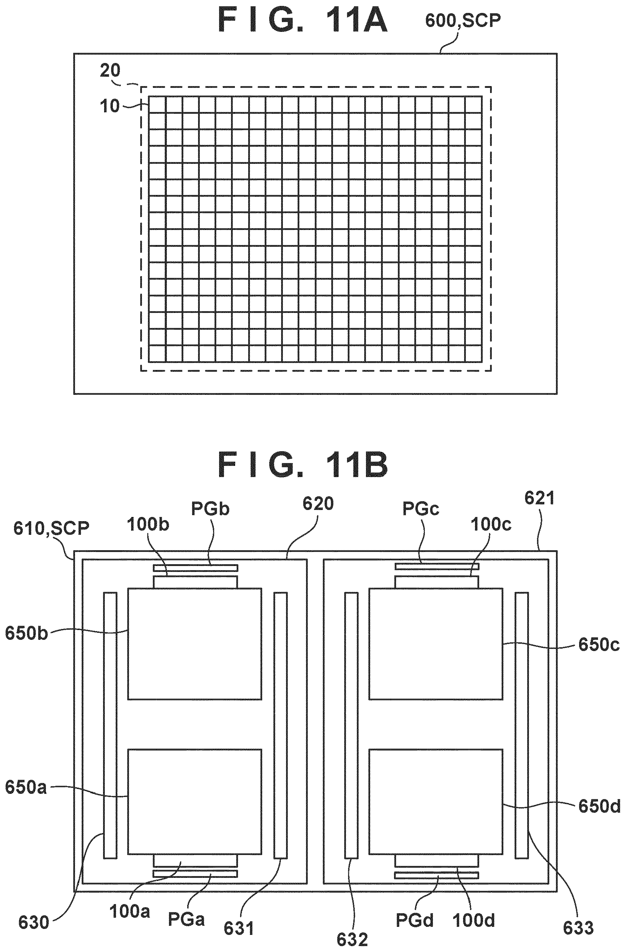

Figs. 11A and 11B illustrate the layout of the photoelectric conversion device PEC. Here, Fig. 11A schematically shows a pixel substrate 600, and Fig. 11B schematically shows a circuit substrate 610. The photoelectric conversion device PEC is formed as a semiconductor chip SCP that includes a stacked structure formed by the pixel substrate 600 and the circuit substrate 610. The pixel array 20 is arranged on the pixel substrate 600. Signal processors 620 and 621 can be arranged on the circuit substrate 610. The left half region (signal processor 620) and right half region (signal processor 621) of the circuit substrate 610 can be manufactured by exposing the substrate in two steps using a common mask set. In this case, the signal processors 620 and 621 have substantially the same arrangement. However, by performing collective exposure on only the upper layer metal, the signal processors 620 and 621 can have different connection states.

The circuit substrate 610 can include row selection circuits (vertical scanning circuits) 630 to 633. The row selection circuits (vertical scanning circuits) 630 to 633 can form the above-described row selection circuit 110. The circuit substrate 610 can also include a plurality of signal processors 650a to 650d. The plurality of signal processors 650a to 650d form the above-described signal processor SP. The plurality of signal processors 650a to 650d can have the same arrangement. Each of the plurality of signal processors 650a to 650d can include the plurality of column circuits CC described above. The circuit substrate 610 can include a plurality of output devices 100a to 100d. Each of the plurality of output devices 100a to 100d can have the arrangement similar to that of the above-described output device 100. The signals of the pixels 10 in the rows selected from the plurality of rows of the pixel array 20 by the row selection circuits 630 to 633 can be read out by the plurality of signal processors 650a to 650d of the circuit substrate 610 via joints (not shown) between the substrates. In the example shown in Figs. 11A and 11B, the plurality of output devices 100a to 100d are distributed and arranged in four regions. With this arrangement, it is possible to suppress that the resistances of power supply potential lines and ground potential lines locally increase in the pixel array 20 and the plurality of signal processors 650a to 650d, and suppress a degradation in image quality caused by local shading, crosstalk, or the like.

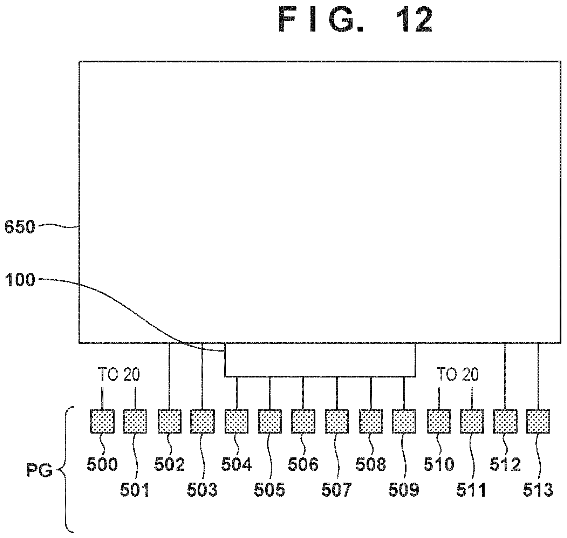

Fig. 12 illustrates the arrangement of the output device 100 (100 represents 100a to 100d), the signal processor 650 (650 represents 650a to 650d), and a pad group PG (PG represents PGa to PGd) connected to the output device 100 and the signal processor 650. The pad group PG can include power supply potential pads 500 and 510 for the pixel array 20 (pixel 10), and ground potential pads 501 and 511 for the pixel array 20 (pixel 10). The power supply potential pads 500 and 510 and the ground potential pads 501 and 511 are electrically connected to the power supply potential line and ground potential line, respectively, of the pixel array 20 via joints (not shown) between the substrates. The pad group PG can also include power supply potential pads 502 and 512 for the signal processor 650 and ground potential pads 503 and 513 for the signal processor 650. In this example, one kind of the power supply potential lines and one kind of the ground potential lines are provided for the signal processor 650, but two or more kinds of the power supply potential lines and two or more kinds of the ground potential lines may be provided. With this, for example, different power supply potential lines and different ground potential lines may be assigned to the current supply circuit 40, the comparator 60, and the first memory 70.

The pad group PG can also include a power supply potential pad 504 for the output device 100, and a ground potential pad 505 for the output device 100. The pad group PG can also include a pair of output pads 506 and 507, and another pair of output pads 508 and 509. When the two pairs of output pads are provided for the output device 100 as in this example, two transmitters 210 are provided in the output device 100. When each of the output devices 100a to 100d includes the two transmitters 210, eight pairs of output pads are provided in total. Note that this is merely an example, and an arbitrary number of output pads can be provided. For example, 12 pairs, 16 pairs, or 20 pairs of output pads can be provided.

In the example shown in Figs. 11A to 12, the photoelectric conversion device PEC includes the plurality of output pads 500 to 512 arranged in the semiconductor chip so as to be driven by the output devices 100a and 100b, and the plurality of output pads 500 to 512 are arranged along at least one side of the semiconductor chip. Further, at least one of the power supply potential pads 502 and 512 and ground potential pads 503 and 513 for the signal processors 650a to 650d and the plurality of output pads 506, 507, 508, and 509 are arranged along at least one side of the semiconductor chip. Here, at least one side can be a long side of the semiconductor chip.

In the example shown in Figs. 11A to 12, the signal processors 650a to 650d include the signal processor (for example, the signal processor 650a) constituting a first signal processor group, and the signal processor (for example, the signal processor 650d) constituting a second signal processor group. Further, the output devices 100a to 100d include a first output device (for example, the output device 100a) provided for the first signal processor group, and a second output device (for example, the output device 100d) provided for the second signal processor group. The plurality of output pads provided in the semiconductor chip SCP include a first output pad group (for example, PGa) provided for the first output device, and a second output pad group (for example, PGd) provided for the second output device. The first output pad group and the second output pad group are arranged along at least one side of the semiconductor chip SCP.

In the example shown in Figs. 11A to 12, the pad groups PGa and PGd (multiple output pads) for the output devices 100a and 100d and the pad groups PGb and PGc (multiple output pads) for the output devices 100b and 100c are distributed and arranged along two opposite sides of the semiconductor chip. At least one of the power supply potential pads 502 and 512 and ground potential pads 503 and 513 for the signal processors 650a and 650d and the multiple output pads 506, 507, 508, and 509 are arranged along one of the two opposite sides of the semiconductor chip. At least one of the power supply potential pads 502 and 512 and ground potential pads 503 and 513 for the signal processors 650c and 650b and the multiple output pads 506, 507, 508, and 509 are arranged along the other of the two opposite sides of the semiconductor chip. Here, the two opposite sides can be long sides of the semiconductor chip.

In the example shown in Figs. 11A to 12, the signal processors 650a to 650d include the signal processor (for example, the signal processor 650a) constituting a first signal processor group, and the signal processor (for example, the signal processor 650b) constituting a second signal processor group. Further, the output devices 100a to 100d include a first output device (for example, the output device 100a) provided for the first signal processor group, and a second output device (for example, the output device 100b) provided for the second signal processor group. The plurality of output pads provided in the semiconductor chip SCP include a first output pad group (for example, PGa) provided for the first output device, and a second output pad group (for example, PGb) provided for the second output device. The first output pad group is arranged along one of the two opposite sides of the semiconductor chip, and the second output pad group is arranged along the other of the two opposite sides.

In the example shown in Figs. 11A to 12, the power supply potential pads 502 and 512 and ground potential pads 503 and 513 for at least one of the pixel array 20 and the signal processors 650a to 650d are provided. Further, in the example shown in Figs. 11A to 12, the power supply potential pad 504 and ground potential pad 505 for the output devices 100 to 103 are provided. The power supply potential pad 504 can be provided independently of the power supply potential pads 502 and 512. The ground potential pad 505 can be provided independently of the ground potential pads 503 and 513.

In the first embodiment, in addition to reducing the total number of output pads by including the output devices 100 to 103, each of which can output four amplitude values, the number of output pads in one region is reduced by distributing and arranging the output devices 100 to 103 in the plurality of regions. For example, if the output devices are not distributed, eight pairs of output pads are provided in one region. However, in the example shown in Fig. 12, the number of pairs of the output pads 506 to 509 in one region can be reduced to two. This can reduce the region where the power supply potential pads and ground potential pads for the pixel array 20 and signal processors (for example, A/D conversion devices) 650a to 650d cannot be arranged. This is advantageous in suppressing a local increase in resistance of the power supply potential line or the ground potential line in the pixel array 20 and the signal processors 650a to 650d, and suppressing a degradation in image quality caused by local shading, crosstalk, and the like.

In addition, in the first embodiment, the power supply potential pad and ground potential pad for the output device 100 and the power supply potential pads and ground potential pads for the signal processor 650 are separately arranged. As has been described with reference to Figs. 6 to 9, the resistance between the power supply potential and the ground potential is 166 Ω in the operation states shown in Figs. 6 and 7, and the resistance between the power supply potential and the ground potential is 250 Ω in the operation states shown in Figs. 8 and 9. That is, the current consumption changes in accordance with the combination of the serial signals in<1> and in<0>. In the example shown in Figs. 11A and 11B, since the power supply potential pads and the ground potential pads for the signal processor 650 are separately arranged, a degradation in image quality, which occurs when the power supply potential and ground potential of the signal processor 650 fluctuate due to the current fluctuation of the output device 100, is suppressed.

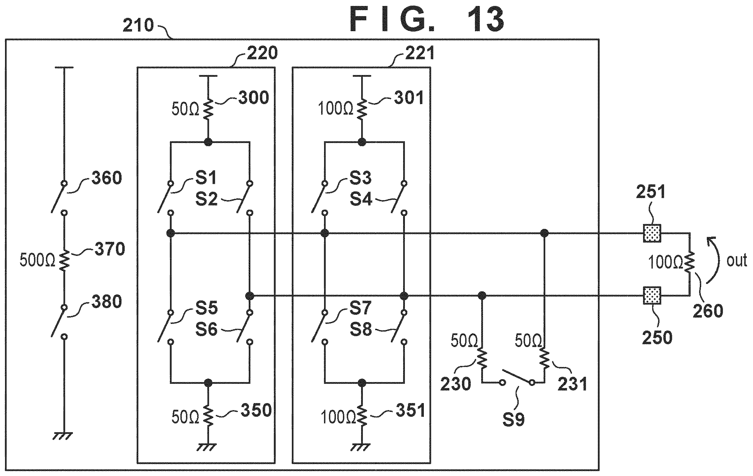

Fig. 13 shows a first modification of the transmitter 210 in the photoelectric conversion device PEC according to the first embodiment. In the first modification, in addition to the components described above, the transmitter 210 can include switches 360 and 380 and a resistor 370 arranged in series between the power supply potential line and the ground potential line. In the operation state shown in Fig. 6 or 7, that is, in the case of in<1> = 0 and in<0> = 0 or in the case of in<1> = 1 and in<0> = 1, each of the switches 360 and 380 is set in an OFF state. On the other hand, in the operation state shown in Fig. 8 or 9, that is, in the case of in<1> = 0 and in<0> = 1 or in the case of in<1> = 1 and in<0> = 0, each of the switches 360 and 380 is set in an ON state. With this, a change in current consumption of the transmitter 210 according to a change of the combination of the values of the serial signals in<1> and in<0> is suppressed. Accordingly, it is possible to suppress fluctuations in power supply potential and ground potential of the transmitter 210 so that the transmitter 210 can operate stably. The influence of the change in current consumption of the transmitter 210 on the signal processor 650 is reduced, so that a degradation in image quality can be suppressed.

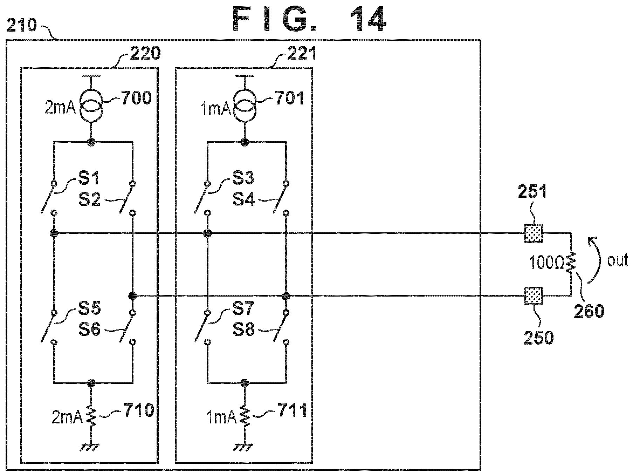

Fig. 14 shows a second modification of the transmitter 210 in the photoelectric conversion device PEC according to the first embodiment. In the second modification, the resistors 300, 301, 350, and 351 in the transmitter 210 according to the first embodiment are replaced with current sources 700, 701, 710, and 711, respectively. With this arrangement, a change in current consumption of the transmitter 210 according to a change of the combination of the values of the serial signals in<1> and in<0> is suppressed. However, when using the current source, it is required to keep the voltages at both ends of the current source above a certain level. Therefore, in terms of reducing the voltage and reducing the power, the arrangement shown in Fig. 13 is preferable.

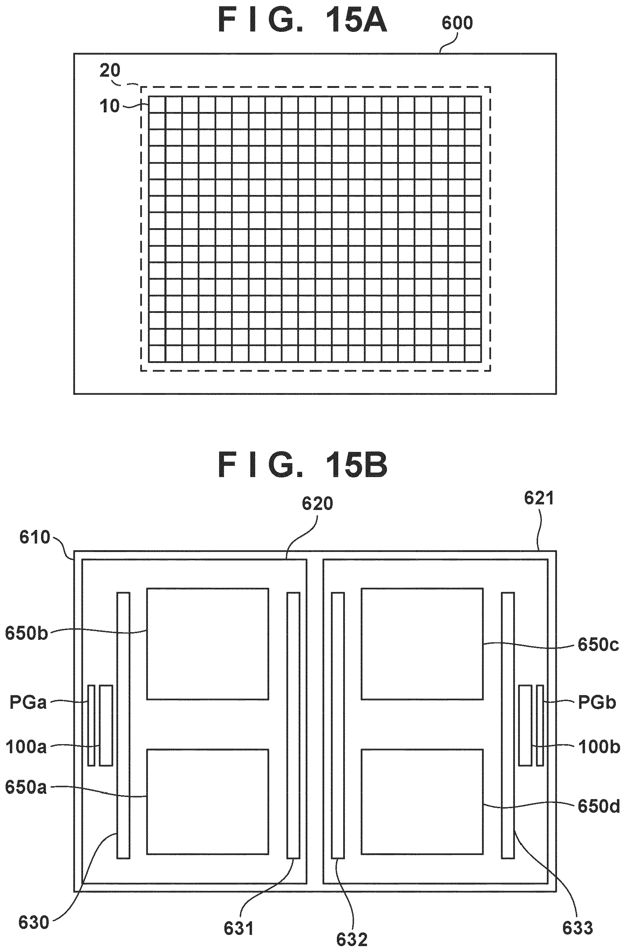

Figs. 15A and 15B show a third modification of the transmitter 210 in the photoelectric conversion device PEC according to the first embodiment. In the third modification, the output devices 100a and 100b are arranged along short sides of the semiconductor chip, respectively, and the pad groups PGa and PGb are also arranged along the short sides of the semiconductor chip, respectively. In the example shown in Figs. 11A and 11B, the output devices 100a to 100d are arranged along the long sides of the semiconductor chip, and this suppresses that the characteristics of the plurality of pixels 10 in the pixel array 20 change in the long-side direction. Further, in the example shown in Figs. 11A and 11B, it is suppressed that the characteristics of the plurality of current supply circuits 40 and the plurality of comparators 60 constituting each of the signal processors 650a to 650d change in the long-side direction. On the other hand, in the third modification illustrated in Figs. 15A and 15B, it is suppressed that the characteristics of the plurality of pixels 10 in the pixel array 20 change in the short-side direction, and it is suppressed that the characteristics of the row selection circuits 630 and 633 change in the short-side direction.

Other modifications will be described below. In the example described above, one first vertical signal line is assigned to each pixel column, but an arrangement may be employed in which multiple first vertical signal lines are assigned to each pixel column so that signals of the pixels in multiple rows can be simultaneously read out. The comparator 60 may be formed to include a switch and a capacitance for an auto zero operation.

The photoelectric conversion device PEC may be formed by stacking three or more substrates, or may be formed by one substrate. The photoelectric conversion device PEC may be a front-surface irradiation type photoelectric conversion device or a back-surface irradiation type photoelectric conversion device.

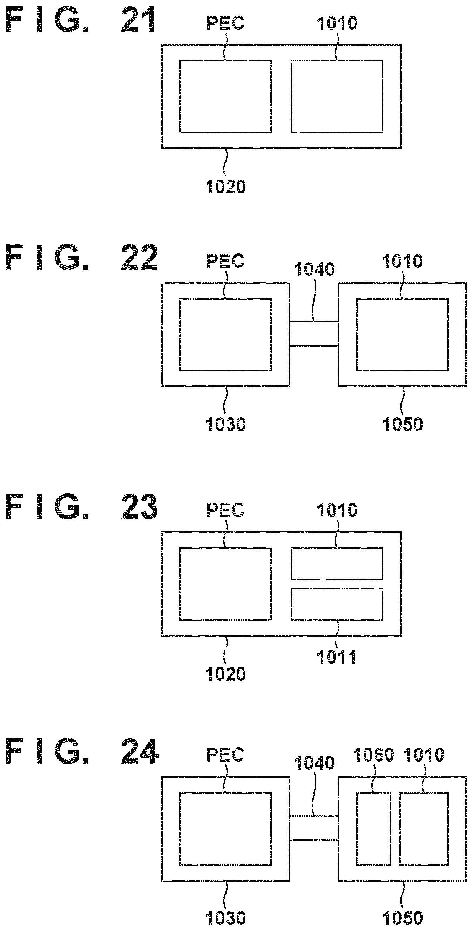

As illustrated in Fig. 21, the photelectric conversion device may be mounted on the same printed board as the signal processing chip to form a system. In the example shown in Fig. 21, the photoelectric conversion device PEC is mounted on a printed board 1020 together with a signal processing chip 1010. An image signal output from the transmitter 210 of the photoelectric conversion device PEC via the output pads 250 and 251 can be transmitted to the signal processing chip 1010 via the inner layer wiring in the printed board 1020, and processed by the signal processing chip 1010. In this embodiment, since the transmitter 210 is configured to be capable of taking four amplitude values, it is possible to reduce the number of transmission lines. This is advantageous in, for example, miniaturization of the printed board 1020, and reduction of radiation noise associated with signal transmission.

It is desirable that the characteristic impedance of the transmission line matches the output impedance of the transmitter 210 as much as possible. In the large amplitude output state shown in Fig. 6, when viewing the transmitter 210 from the output pad 251, the resistor 350 and the resistor 351 are connected in parallel between the output pad 251 and the ground potential, resulting in a combined resistance of about 33 Ω. Similarly, when viewing the transmitter 210 from the output pad 250, the resistor 300 and the resistor 301 are connected in parallel, resulting in a combined resistance of about 33 Ω. In this manner, in the large amplitude output state, the output impedance of the transmitter 210 is about 33 Ω.

On the other hand, in the small amplitude output state shown in Fig. 8, when viewing the transmitter 210 from the output pad 250, the resistor 301 is connected between the output pad 250 and the power supply potential, and the resistors 230, 231, and 351 are connected in series between the output pad 250 and the ground potential. This leads to parallel resistances, one being 100 Ω of the resistor 301 and the other being 200 Ω which is a sum of the resistances of the resistors 230, 231, and 351, resulting in a combined resistance of about 66 Ω. Similarly, when viewing the transmitter 210 from the output pad 251, a combined resistance of about 66 Ω is obtained.

Accordingly, the impedance of the transmission line of the printed board 1020 is desirably between 33 Ω and 66 Ω. That is, the impedance of the transmission line of the printed board 1020 is desirably between the output resistance in the large amplitude output state of the transmitter 210 and the output resistance in the small amplitude output state thereof. As an example, the impedance can be 48 Ω, which is the median value between 33 Ω and 66 Ω. That is, in this example, the output resistance of the transmitter 210 is 33 Ω or 66 Ω, and the impedance of the inner layer wiring is 48 Ω. The output resistance of the transmitter 210 can be adjusted by adjusting the resistance value of the resistor element. For example, the output resistance of the transmitter 210 can be adjusted so as to be 40 Ω for a large amplitude and 60 Ω for a small amplitude. In accordance with this, the impedance of the transmission line can be adjusted to be 50 Ω, which is the median value between 40 Ω and 60 Ω.

A plurality of the transmitters 210 and a plurality of pairs of the output pads 250 and 251 may be provided in the photoelectric conversion device PEC, and a plurality of pairs of transmission lines may be provided in the printed board 1020.

As illustrated in Fig. 22, the photoelectric conversion device PEC may be mounted on a printed board different from the printed board mounted with the signal processing chip. In the example shown in Fig. 22, the photoelectric conversion device PEC is mounted on a sensor printed board 1030, and the signal processing chip 1010 is mounted on a signal processing chip printed board 1050. The sensor printed board 1030 and the signal processing chip printed board 1050 are connected by a flexible substrate 1040. Thus, a system can be formed. An image signal output from the transmitter 210 of the photoelectric conversion device PEC via the output pads 250 and 251 is transmitted to the signal processing chip 1010 via the transmission line in the sensor printed board 1030, the flexible substrate 1040, and the transmission line in the signal processing chip printed board 1050. In this embodiment, since the transmitter 210 is configured to be capable of taking four amplitude values, it is possible to reduce the number of wirings included in the flexible substrate 1040 in addition to the number of transmission lines. This is advantageous in miniaturization of the flexible substrate, and reduction of radiation noise associated with signal transmission in the flexible substrate. The flexible substrate 1040 is merely an example of a connection portion and, for example, a coaxial cable or the like may be used instead.

As illustrated in Fig. 23, the photoelectric conversion device PEC may output an image signal to a plurality of signal processing chips. In the example shown in Fig. 23, the photoelectric conversion device PEC is mounted on the printed board 1020 together with the signal processing chip 1010 and a signal processing chip 1011. Thus, a system can be formed. When the plurality of signal processing chips 1010 and 1011 perform processing in parallel, high-speed signal processing is implemented.

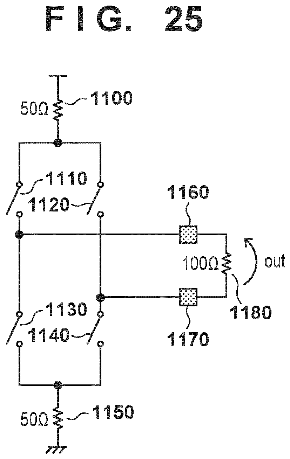

In another system, the photoelectric conversion device PEC may output an image signal to a preprocessing chip, and the preprocessing chip may output the image signal to the signal processing chip. In such an arrangement, the signal transmission from the preprocessing chip to the signal processing chip may be transmission based on only two amplitude values, or may be transmission based on three or more amplitude values. Figs. 24 and 25 show an example. In Fig. 24, a preprocessing chip 1060 and the signal processing chip 1010 are mounted on the signal processing chip printed board 1050. The sensor printed board 1030 and the signal processing chip printed board 1050 can be connected by the flexible substrate 1040. The preprocessing chip 1060 receives an image signal transmitted from the photoelectric conversion device PEC via the flexible substrate 1040, and then outputs the image signal to the signal processing chip 1010. In order to output the image signal to the signal processing chip 1010, the preprocessing chip 1060 can include, for example, a transmitter (second output device) that performs transmission based on two amplitude values as illustrated in Fig. 25. The transmitter illustrated in Fig. 25 can include resistors 1100 and 1150, switches 1110, 1120, 1130, and 1140, and output pads 1160 and 1170. The signal processing chip 1010 can include a resistor 1180 that connects the output pads 1160 and 1170. If the switches 1120 and 1130 are turned on and the switches 1110 and 1140 are turned off, a positive output amplitude is obtained. If the switches 1120 and 1130 are turned off and the switches 1110 and 1140 are turned on, a negative output amplitude is obtained. That is, the transmitter illustrated in Fig. 25 is configured to perform transmission based on two amplitude values. In this manner, when it is configured such that signal transmission from the photoelectric conversion device PEC to the preprocessing chip 1060 is performed based on three or more amplitude values, and signal transmission from the preprocessing chip 1060 to the signal processing chip 1010 is performed based on only two amplitude values, merits as described below can be obtained. First, as has been described above, it is possible to miniaturize the flexible substrate, and reduce radiation noise associated with signal transmission in the flexible substrate. In addition, since the signal transmission to the signal processing chip 1010 is performed based on only two amplitude values, the signal processing chip 1010 can be selected from a wider choice of chips. Processing such as data sorting may be performed in the preprocessing chip 1060. This also allows the signal processing chip 1010 to be selected from a wider choice of chips. The preprocessing chip 1060 can be formed by, for example, an FPGA (Field-Programmable Gate Array) or an ASIC (Application Specific Integrated Circuit).

In addition to the transmitter that outputs an amplitude value selected from three or more amplitude values, the photoelectric conversion device PEC may include a transmitter (second output device) that can take less amplitude values. The photoelectric conversion device PEC can also include, for example, a transmitter that can take two amplitude values as illustrated in Fig. 25. For example, a clock serving as the reference of the operation of the photoelectric conversion device PEC may be output from the transmitter. By transmitting the clock from the photoelectric conversion device PEC to the signal processing chip 1010 in addition to image data, the signal processing chip 1010 can recognize the timing serving as the reference of the image data. This facilitates data acquisition. Further, using the transmitter illustrated in Fig. 25 to output the clock can reduce the number of elements and power consumption more than in a case of using the transmitter described with reference to Figs. 3 to 8.

The photoelectric conversion device PEC may be operated in an operation mode in which the transmitter, which outputs an amplitude value selected from three or more amplitude values, can take less amplitude values. For example, the transmitter that can take four amplitude values has been taken as an example and described in Figs. 3 to 8. However, in Fig. 3, an output operation that can take two amplitude values may be performed by using the parallel/serial convertor 201 and the 1-bit transmitter 221 while constantly rendering the parallel/serial convertor 200 and the 1-bit transmitter 220 inoperative. With this, for example, it is possible to reduce the operating power in a mode in which the output data rate is low.

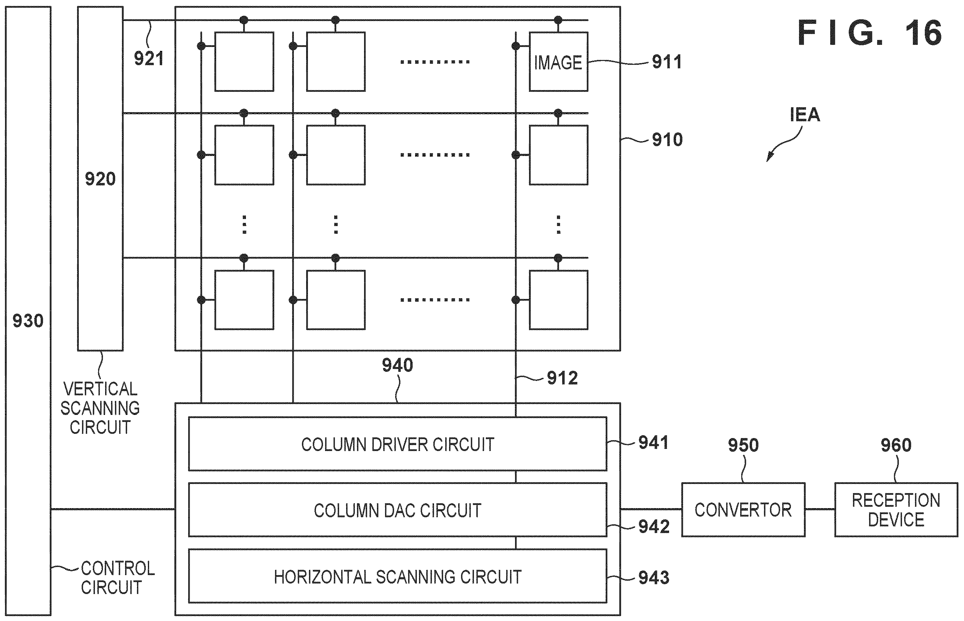

Fig. 16 schematically shows the arrangement of a light emitting device IEA according to the second embodiment. The light emitting device IEA can be formed as, for example, a display device, an illumination device, or a light source. In the example shown in Fig. 16, the light emitting device IEA is formed as a display device. The light emitting device IEA can include a reception device 960, a conversion device 950, and a light emitting unit array (pixel array) 910. The reception device 960 can receive an amplitude modulated signal (a pulse amplitude modulation signal) having an amplitude value selected from three or more (for example, four, six, eight, or the like) amplitude values. The convertor 950 can convert the amplitude modulated signal received by the reception device 960 into a digital signal (binary signal). This is advantageous in widening signal transfer from an external device to the light emitting device IEA.

The light emitting unit array 910 can include a plurality of light emitting units (pixels) 911 whose light emission operations are respectively controlled based on the digital signal converted by the convertor 950. The plurality of light emitting units 911 of the light emitting unit array 910 can be arrayed so as to form a plurality of rows and a plurality of columns.

The light emitting device IEA can further include a vertical scanning circuit 920, a control circuit 930, and a signal output device 940. The vertical scanning circuit 920 can be configured to select the plurality of rows of the light emitting unit array 910 in a predetermined order. This selection is performed by setting each of a plurality of scanning lines 921 provided for the plurality of rows at the active level. The control circuit 930 can control the vertical scanning circuit 920, the control circuit 930, the signal output device 940, the conversion device 950, and the reception device 960. The signal output device 940 can include a column driver circuit 941, a column DAC circuit 942, and a horizontal scanning circuit 943. The column DAC circuit 942 includes a plurality of column DACs (D/A convertors), and each column DAC receives the digital signal supplied from the convertor 950 in accordance with a control signal from the horizontal scanning circuit 943, and converts the digital signal into an analog signal. The column driver circuit 941 includes a plurality of column drivers corresponding to the plurality of column DACs. Each column driver drives a column signal line 912 in accordance with the analog signal supplied from the corresponding column DAC, and provides the analog signal to the light emitting unit 911 in the row selected by the vertical scanning circuit 920.

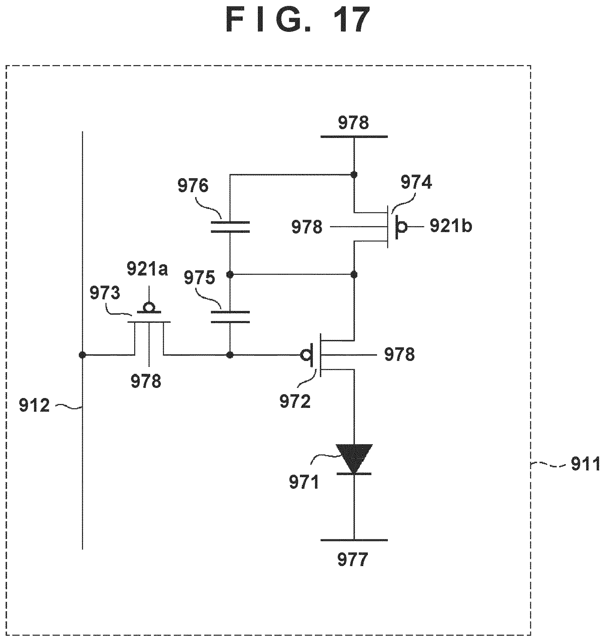

Fig. 17 shows an arrangement example of the light emitting unit (pixel) 911. The light emitting unit 911 can include a light emitting element (for example, organic light emitting element) 971, a driving transistor 972, a writing transistor 973, a light emission control transistor 974, a first capacitive element 975, and a second capacitive element 976. Note that the total number of the transistors and capacitive elements and the combination of the conductivity types of the transistors are merely examples, and the present invention is not limited to this. In the following description, when a transistor is connected between an element A and an element B, this can mean a form in which one of the source and the drain of the transistor is connected to one of the element A and the element B, and the other of the source and the drain of the transistor is connected to other of the element A and the element B.

One of the source and drain of the driving transistor 972 can be connected to the first electrode of the light emitting element 971. The first electrode is, for example, an anode. The second electrode of the light emitting element 971 can be connected to a first power supply potential 977 (to be referred to as a Vss hereinafter). The second electrode is, for example, a cathode. One of the source and drain of the writing transistor 973 can be connected to the gate of the driving transistor 972, and the other of the source and drain of the writing transistor 973 can be connected to the column signal line 912. The gate of the writing transistor 973 can be connected to a first scanning line 921a. One of the source and drain of the light emission control transistor 974 can be connected to the other of the source and drain of the driving transistor 972. The other of the source and drain of the light emission control transistor 974 can be connected to a second power supply potential 978 (to be referred to as a Vdd hereinafter). The gate of the light emission control transistor 974 can be connected to a second scanning line 921b.

Note that in the example shown in Fig. 17, the light emitting unit 911 is formed by a p-type transistor, the drain of the driving transistor 972 is connected to the anode of the light emitting element 971, and the drain of the light emission control transistor 974 is connected to the source of the driving transistor 972. Further, the cathode of the light emitting element 971 is connected to the Vss.

Here, in any transistor, the Vdd 978 is applied to the back gate. The first capacitive element 975 can be connected between the gate and source of the driving transistor 972. The second capacitive element 976 can be connected between the source of the driving transistor 972 and the Vdd 978.

The driving transistor 972 supplies a current from the Vdd 978 via the light emission control transistor 974 to the light emitting element 971, thereby causing the light emitting element 971 to emit light. More specifically, the driving transistor 972 supplies a current corresponding to the signal voltage held in the first capacitive element 975 from the Vdd 978 to the light emitting element 971. Thus, the light emitting element 971 is current-driven to emit light.

The writing transistor 973 changes to a conductive state in response to a writing signal applied to the gate from the vertical scanning circuit 920 through the first scanning line 921a. Accordingly, the writing transistor 973 samples the signal voltage of a video signal or a reference voltage corresponding to a luminance signal or a reference signal supplied from the signal output device 940 via the column signal line 912, respectively, and writes the sampled voltage in the light emitting unit 911. The written signal voltage or reference voltage is applied to the gate of the driving transistor 972 and held in the first capacitive element 975.

The light emission control transistor 974 changes to a conductive state or a nonconductive state in response to a light emission control signal applied to the gate from the vertical scanning circuit 920 via the second scanning line 921b. With this, it can control supply of a current from the Vdd 978 to the driving transistor 972. Then, as has been described above, the driving transistor 972 can cause the light emitting element 971 to emit light. That is, the light emission control transistor 974 has a function as a transistor that controls light emission/non-light emission of the light emitting element 971.

In this manner, a period during which the light emitting element 971 is in a non-light emission state (non-light emission period) is provided by the switching operation of the light emission control transistor 974, so that the ratio of the light emission period and the non-light emission period of the light emitting element 971 can be controlled (so-called duty control). With this duty control, afterimages associated with the light emission of the light emitting elements 971 over one frame period can be reduced, and in particular, the quality of a moving image can be further improved.

When the organic EL (Organic Electroluminescent) element as the light emitting element 971 emits light, the light emitting device IEA changes the amount of a current flowing to the driving transistor 972 in accordance with the luminance of the video signal. To do this, the capacitance between the first electrode and the second electrode of the light emitting element 971 is charged to a predetermined potential so that a current corresponding to the potential difference flows. Thus, the light emitting element 971 emits light with predetermined luminance.

An embodiment of a photoelectric conversion system using the photoelectric conversion device PEC according to the first embodiment will be described below.

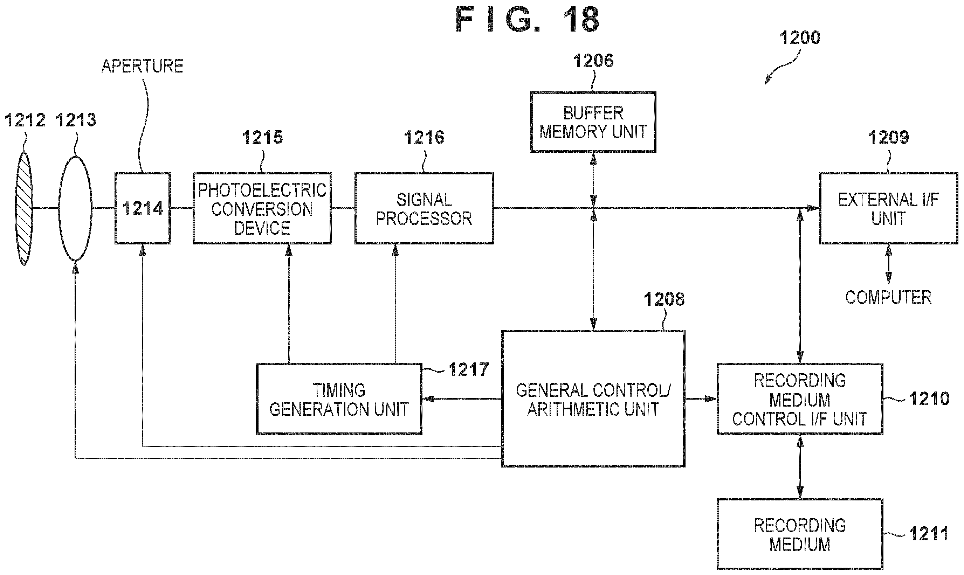

Fig. 18 is a block diagram showing the arrangement of a photoelectric conversion system 1200 according to this embodiment. The photoelectric conversion system 1200 according to this embodiment includes a photoelectric conversion device 1215. Here, the photoelectric conversion device 1215 can be the photoelectric conversion device PEC described in the first embodiment. The photoelectric conversion system 1200 can be used as, for example, an image capturing system. Practical examples of the image capturing system are a digital still camera, a digital camcorder, and a monitoring camera. Fig. 18 shows an example of a digital still camera as the photoelectric conversion system 1200.

The photoelectric conversion system 1200 shown in Fig. 18 includes the photoelectric conversion device 1215, a lens 1213 for forming an optical image of an object on the photoelectric conversion device 1215, an aperture 1214 for changing the amount of light passing through the lens 1213, and a barrier 1212 for protecting the lens 1213. The lens 1213 and the aperture 1214 form an optical system for concentrating light to the photoelectric conversion device 1215.

The photoelectric conversion system 1200 includes a signal processor 1216 for processing an output signal output from the photoelectric conversion device 1215. The signal processor 1216 performs an operation of signal processing of performing various kinds of correction and compression for an input signal, as needed, thereby outputting the resultant signal. The photoelectric conversion system 1200 further includes a buffer memory unit 1206 for temporarily storing image data and an external interface unit (external I/F unit) 1209 for communicating with an external computer or the like. Furthermore, the photoelectric conversion system 1200 includes a recording medium 1211 such as a semiconductor memory for recording or reading out image capturing data, and a recording medium control interface unit (recording medium control I/F unit) 1210 for performing a recording or reading operation in or from the recording medium 1211. The recording medium 1211 may be incorporated in the photoelectric conversion system 1200 or may be detachable. In addition, communication with the recording medium 1211 from the recording medium control I/F unit 1210 or communication from the external I/F unit 1209 may be performed wirelessly.

Furthermore, the photoelectric conversion system 1200 includes a general control/arithmetic unit 1208 that performs various kinds of arithmetic operations and controls the entire digital still camera, and a timing generation unit 1217 that outputs various kinds of timing signals to the photoelectric conversion device 1215 and the signal processor 1216. Here, the timing signal and the like may be input from the outside, and the photoelectric conversion system 1200 need only include at least the photoelectric conversion device 1215 and the signal processor 1216 that processes an output signal output from the photoelectric conversion device 1215. As described in the fourth embodiment, the timing generation unit 1217 may be incorporated in the photoelectric conversion device. The general control/arithmetic unit 1208 and the timing generation unit 1217 may be configured to perform some or all of the control functions of the photoelectric conversion device 1215.

The photoelectric conversion device 1215 outputs an image signal to the signal processor 1216. The signal processor 1216 performs predetermined signal processing for the image signal output from the photoelectric conversion device 1215 and outputs image data. The signal processor 1216 also generates an image using the image signal. Furthermore, the signal processor 1216 may perform distance measurement calculation for the signal output from the photoelectric conversion device 1215. Note that the signal processor 1216 and the timing generation unit 1217 may be incorporated in the photoelectric conversion device. That is, each of the signal processor 1216 and the timing generation unit 1217 may be provided on a substrate on which pixels are arranged or may be provided on another substrate. An image capturing system capable of acquiring a higher-quality image can be implemented by forming an image capturing system using the photoelectric conversion device of each of the above-described embodiments.

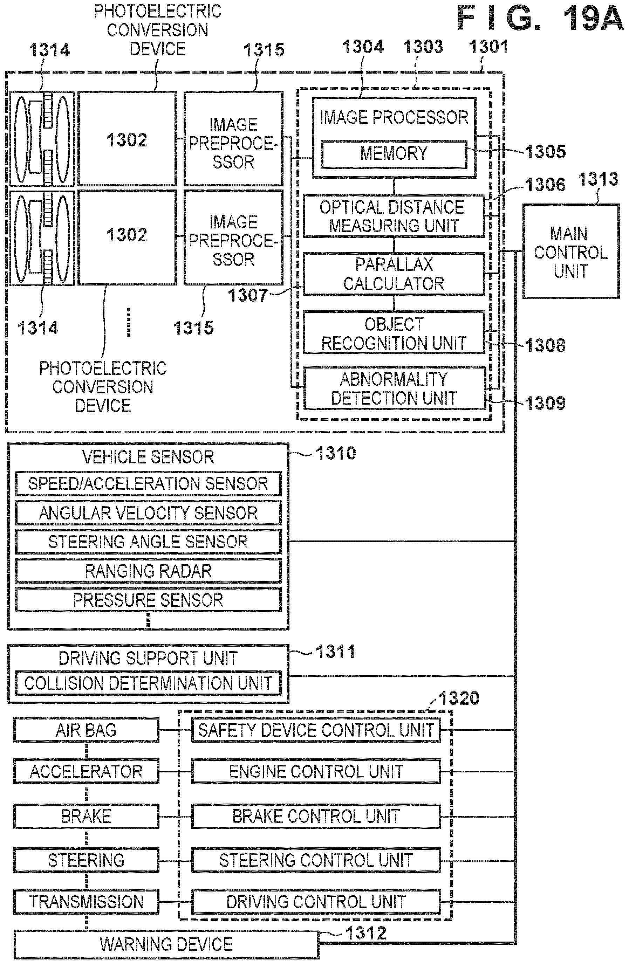

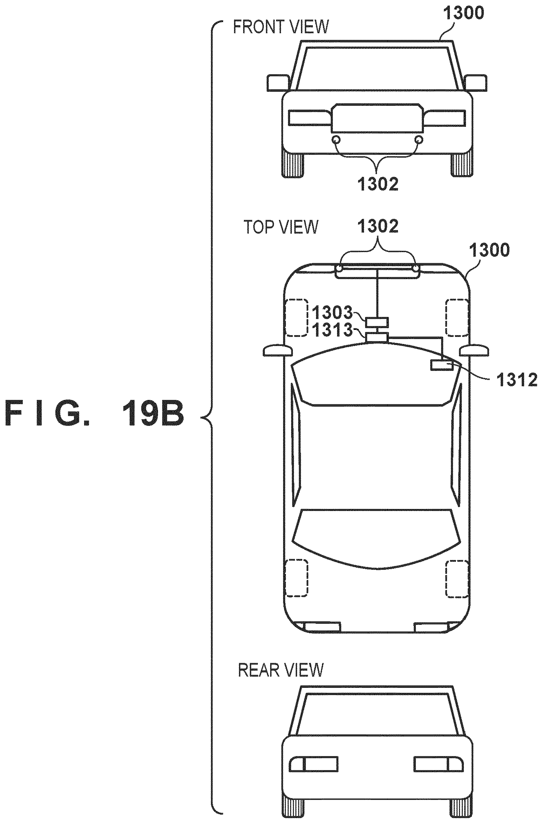

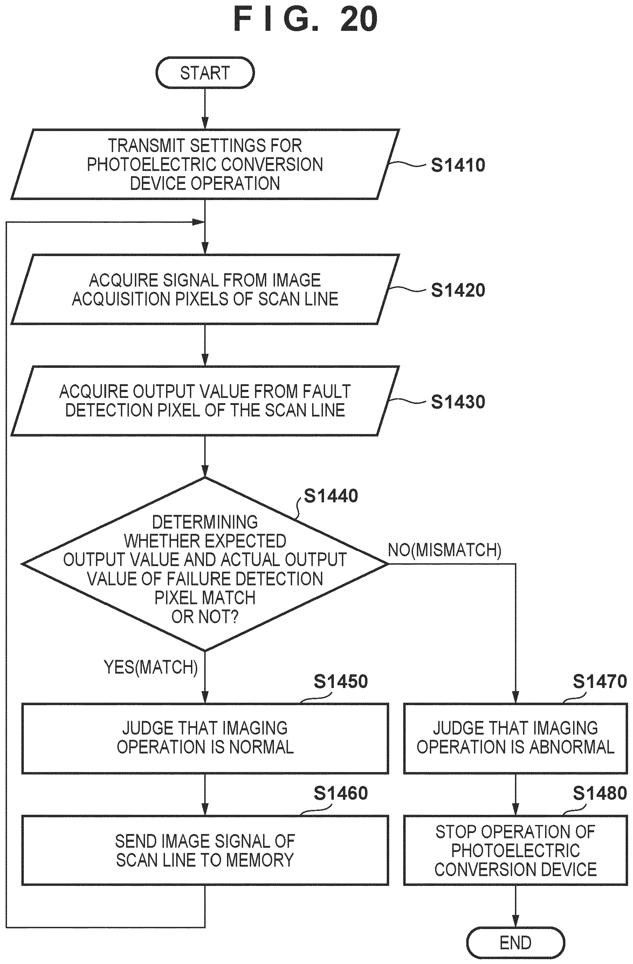

A photoelectric conversion system and a moving body according to this embodiment will be described with reference to Figs. 19A to 20. Figs. 19A and 19B are schematic views showing an arrangement example of the photoelectric conversion system and an arrangement example of the moving body, respectively, according to this embodiment. Fig. 20 is a flowchart illustrating an operation of the photoelectric conversion system according to this embodiment. In this embodiment, an example of an in-vehicle camera will be described as the photoelectric conversion system.

Figs. 19A and 19B show examples of a vehicle system and a photoelectric conversion system that is incorporated in the vehicle system and performs image capturing. A photoelectric conversion system 1301 includes a photoelectric conversion device 1302, an image preprocessor 1315, an integrated circuit 1303, and an optical system 1314. The optical system 1314 forms an optical image of an object on the photoelectric conversion device 1302. The photoelectric conversion device 1302 converts, into an electrical signal, the optical image of the object formed by the optical system 1314. The photoelectric conversion device 1302 is the photoelectric conversion device according to any one of the above-described embodiments. The image preprocessor 1315 performs predetermined signal processing for the signal output from the photoelectric conversion device 1302. The function of the image preprocessor 1315 may be incorporated in the photoelectric conversion device 1302. In the photoelectric conversion system 1301, at least two sets of the optical systems 1314, the photoelectric conversion devices 1302, and the image preprocessors 1315 are arranged, and an output from the image preprocessor 1315 of each set is input to the integrated circuit 1303.

The integrated circuit 1303 is an image capturing system application specific integrated circuit, and includes an image processor 1304 with a memory 1305, an optical distance measurement unit 1306, a distance measurement calculation unit 1307, an object recognition unit 1308, and an abnormality detection unit 1309. The image processor 1304 performs image processing such as development processing and defect correction for the output signal from each image preprocessor 1315. The memory 1305 temporarily stores a captured image, and stores the position of a defect in the captured image. The optical distance measurement unit 1306 performs focusing or distance measurement of an object. The distance measurement calculation unit 1307 calculates distance measurement information from a plurality of image data acquired by the plurality of photoelectric conversion devices 1302. The object recognition unit 1308 recognizes objects such as a vehicle, a road, a road sign, and a person. Upon detecting an abnormality of the photoelectric conversion device 1302, the abnormality detection unit 1309 notifies a main control unit 1313 of the abnormality.

The integrated circuit 1303 may be implemented by dedicated hardware, a software module, or a combination thereof. Alternatively, the integrated circuit 1303 may be implemented by an FPGA (Field Programmable Gate Array), an ASIC (Application Specific Integrated Circuit), or a combination thereof.

The main control unit 1313 comprehensively controls the operations of the photoelectric conversion system 1301, vehicle sensors 1310, a control unit 1320, and the like. A method in which the photoelectric conversion system 1301, the vehicle sensors 1310, and the control unit 1320 each individually include a communication interface and transmit/receive control signals via a communication network (for example, CAN standards) may be adopted without providing the main control unit 1313.

The integrated circuit 1303 has a function of transmitting a control signal or a setting value to each photoelectric conversion device 1302 by receiving the control signal from the main control unit 1313 or by its own control unit.

The photoelectric conversion system 1301 is connected to the vehicle sensors 1310 and can detect the traveling state of the self-vehicle such as the vehicle speed, the yaw rate, and the steering angle, the external environment of the self-vehicle, and the states of other vehicles and obstacles. The vehicle sensors 1310 also serve as a distance information acquisition unit that acquires distance information to a target object. Furthermore, the photoelectric conversion system 1301 is connected to a driving support control unit 1311 that performs various driving support operations such as automatic steering, adaptive cruise control, and anti-collision function. More specifically, with respect to a collision determination function, based on the detection results from the photoelectric conversion system 1301 and the vehicle sensors 1310, a collision with another vehicle or an obstacle is estimated or the presence/absence of a collision is determined. This performs control to avoid a collision when the collision is estimated or activates a safety apparatus at the time of a collision.

Furthermore, the photoelectric conversion system 1301 is also connected to an alarming device 1312 that generates an alarm to the driver based on the determination result of a collision determination unit. For example, if the determination result of the collision determination unit indicates that the possibility of a collision is high, the main control unit 1313 performs vehicle control to avoid a collision or reduce damage by braking, releasing the accelerator pedal, or suppressing the engine output. The alarming device 1312 sounds an alarm such as a sound, displays alarming information on the screen of a display unit such as a car navigation system or a meter panel, applies a vibration to the seat belt or a steering wheel, thereby giving an alarm to the user.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

A photoelectric conversion device includes a pixel array including a plurality of pixels, a signal processor including an A/D conversion device configured to convert an analog signal output from the pixel array into a digital signal, and an output device configured to output, based on a signal output from the signal processor, an amplitude modulated signal having an amplitude value selected from three or more amplitude values.

## Claims

1. A photoelectric conversion device comprising:
a pixel array including a plurality of pixels;
a signal processor including an A/D conversion device configured to convert an analog signal output from the pixel array into a digital signal; and
an output device configured to output, based on a signal output from the signal processor, an amplitude modulated signal having an amplitude value selected from three or more amplitude values.

2. The photoelectric conversion device according to claim 1, wherein
the output device outputs the amplitude modulated signal based on signal values of identical bits of two digital signals output from the signal processor for two pixels of the plurality of pixels.

3. The photoelectric conversion device according to claim 1, further comprising
a plurality of output pads arranged in a semiconductor chip so as to be driven by the output device,
wherein the plurality of output pads are arranged along at least one side of the semiconductor chip.

4. The photoelectric conversion device according to claim 3, wherein
at least one of a power supply potential pad and a ground potential pad for the A/D conversion device and the plurality of output pads are arranged along the at least one side.

5. The photoelectric conversion device according to claim 3, wherein
the at least one side is a long side of the semiconductor chip.

6. The photoelectric conversion device according to claim 3, wherein
the signal processor includes a first signal processor group and a second signal processor group,
the output device includes a first output device provided for the first signal processor group, and a second output device provided for the second signal processor group,
the plurality of output pads include a first output pad group provided for the first output device, and a second output pad group provided for the second output device, and
the first output pad group and the second output group are arranged along the at least one side.

7. The photoelectric conversion device according to claim 1, further comprising
a plurality of output pads arranged in a semiconductor chip so as to be driven by the output device,
wherein the plurality of output pads are distributed and arranged along two opposite sides of the semiconductor chip.

8. The photoelectric conversion device according to claim 7, wherein
at least one of a plurality of power supply potential pads and a plurality of ground potential pads for the signal processor and at least one of the plurality of output pads are arranged along each of the two opposite sides.

9. The photoelectric conversion device according to claim 7, wherein
the two opposite sides are long sides of the semiconductor chip.

10. The photoelectric conversion device according to claim 7, wherein
the signal processor includes a first signal processor group and a second signal processor group,
the output device includes a first output device provided for the first signal processor group, and a second output device provided for the second signal processor group,
the plurality of output pads include a first output pad group provided for the first output device, and a second output pad group provided for the second output device, and
the first output pad group is arranged along one of the two opposite sides, and the second output pad group is arranged along the other of the two opposite sides.

11. The photoelectric conversion device according to claim 1, wherein
at least one of a power supply potential pad and a ground potential pad for the output device is provided separately from at least one of a power supply potential pad and a ground potential pad for at least one of the pixel array and the signal processor.

12. The photoelectric conversion device according to claim 1, wherein
a parallel signal is output from the signal processor, and
the output device includes a parallel/serial convertor configured to convert the parallel signal output from the signal processor into a serial signal, and a transmitter configured to generate the amplitude modulated signal based on the serial signal output from the parallel/serial convertor.

13. The photoelectric conversion device according to claim 12, wherein
the output device includes a voltage dividing circuit capable of changing a voltage division ratio, and generates the amplitude modulated signal by changing the voltage division ratio of the voltage dividing circuit.

14. The photoelectric conversion device according to claim 13, wherein
the output device further includes a decoder configured to generate, based on the serial signal, a signal used to control the voltage division circuit.

15. The photoelectric conversion device according to claim 1, further comprising
a second output device configured to output a signal based on a signal output from the signal processor,
wherein the signal output by the second output device can have the number of amplitude values smaller than that of the amplitude modulated signal output from the output device.

16. The photoelectric conversion device according to claim 1, wherein
the output device
outputs, in a first operation mode, the amplitude modulated signal having an amplitude value selected from three or more amplitude values, and
outputs, in a second operation mode, an amplitude modulated signal that can have the number of amplitude values smaller than that of the amplitude modulated signal output from the output device in the first operation mode.

17. The photoelectric conversion device according to claim 1, wherein the amplitude modulated signal is a pulse amplitude modulation signal.

18. The photoelectric conversion device according to claim 1, wherein the an output device configured to output the amplitude modulated signal having an amplitude value selected from four amplitude values.

19. A photoelectric conversion system comprising:
a photoelectric conversion device defined in any one of claims 1 to 18; and
a signal processor configured to process a signal output by the photoelectric conversion device.

20. A moving body that comprising
a photoelectric conversion device defined in any one of claims 1 to 18, and
a distance information acquiring unit configured to acquire, from distance measurement information based on a signal from the photoelectric conversion device, distance information to a target object, further comprising
a control unit configured to control the moving body based on the distance information.

21. A system comprising:
a photoelectric conversion device defined in any one of claims 1 to 18; and
a signal processing chip configured to receive and process an image signal output from an output device of the photoelectric conversion device,
wherein the photoelectric conversion device and the signal processing chip are mounted on one substrate.

22. A system comprising:
a first substrate mounted with a photoelectric conversion device defined in any one of claims 1 to 18; and
a second substrate mounted with a signal processing chip configured to receive and process an image signal output from an output device of the photoelectric conversion device mounted on the first substrate.

23. A system comprising:
a photoelectric conversion device defined in any one of claims 1 to 18; and
a plurality of signal processing chips each configured to receive and process an image signal output from an output device of the photoelectric conversion device,
wherein the photoelectric conversion device and the plurality of signal processing chips are mounted on one substrate.

24. A system comprising:
a photoelectric conversion device defined in any one of claims 1 to 18;
a preprocessing chip configured to receive and process an image signal output from an output device of the photoelectric conversion device; and
a signal processing chip configured to process a signal output from the preprocessing chip.

25. The system according to claim 24, wherein
an amplitude modulated signal output from the preprocessing chip can have the number of amplitude values smaller than that of an amplitude modulated signal output from the output device.

26. A light emitting device comprising:
a reception device configured to receive an amplitude modulated signal having an amplitude value selected from three or more amplitude values;
a conversion device configured to convert the amplitude modulated signal into a digital signal; and
a light emitting unit array including a plurality of light emitting units each controlled to emit light based on the digital signal converted by the conversion device.

27. The light emitting device according to claim 26, wherein
the reception device receives the amplitude modulated signal based on signal values of identical bits of two digital signals output from outside of the light emitting device.

28. The light emitting device according to claim 26, wherein the amplitude modulated signal is a pulse amplitude modulation signal.

29. The light emitting device according to claim 26, wherein the reception device configured to receive the amplitude modulated signal having an amplitude value selected from four amplitude values.
